Europäisches Patentamt

European Patent Office

Office européen des brevets

(19)

(11) Veröffentlichungsnummer: **0 052 860**
**B1**

(12) **EUROPÄISCHE PATENTSCHRIFT**

(45) Veröffentlichungstag der Patentschrift:
03.09.86

(51) Int. Cl.⁴: **H 01 L 27/06**

(21) Anmeldenummer: **81109760.9**

(22) Anmeldetag: **19.11.81**

(54) Monolithisch integrierte Gleichrichter-Brückenschaltung.

(30) Priorität: **26.11.80 DE 3044444**

(43) Veröffentlichungstag der Anmeldung:
**02.06.82 Patentblatt 82/22**

(45) Bekanntmachung des Hinweises auf die Patenterteilung:
**03.09.86 Patentblatt 86/36**

(84) Benannte Vertragsstaaten:
**DE FR GB IT NL**

(56) Entgegenhaltungen:
**DE-B-1 639 177**

**IBM TECHNICAL DISCLOSURE BULLETIN Band 20,
Heft 11 A, April 1978 New York P. HUMMEL "Onchip substrate voltage generator" Seiten 4528 bis
4529**

(73) Patentinhaber: **Deutsche ITT Industries GmbH,
Hans- Bunte- Strasse 19 Postfach 840, D-7800
Freiburg (DE)**

(84) Benannte Vertragsstaaten: **DE**

(73) Patentinhaber: **ITT INDUSTRIES INC., 320 Park
Avenue, New York, NY 10022 (US)**

(84) Benannte Vertragsstaaten: **FR GB IT NL**

(72) Erfinder: **Gerlach, Albrecht, Dr., Allmendsberg 31,
D-7831 Freiamt (DE)**

(74) Vertreter: **Morstadt, Volker, Dipl.- Ing., c/o
Deutsche ITT Industries GmbH
Patent/Lizenzabteilung Postfach 840 Hans- Bunte-
Strasse 19, D-7800 Freiburg/Brsg. (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 052 860 B1

## Beschreibung

Die Erfindung betrifft eine monolithisch integrierte Gleichrichter-Brückenschaltung nach dem Oberbegriff des Anspruchs 1, wie sie in IBM-Technical Disclosure Bulletin, Vol. 20, No. 11A, April 1978, S.4528-4529 beschrieben ist.

Die Speisegleichspannung von integrierten Schaltungen kann aus einer Wechselspannung mit Hilfe einer Diodenelemente enthaltenden Gleichrichterbrücke gewonnen werden. Es liegt der Gedanke nahe, die Brücke mitzuintegrieren. Dabei ergibt sich jedoch bei Vervendung bipolarer Elemente eine in der DE-A 16 39 177 geschilderte Problematik, nämlich die Wirkung der auftretenden parasitären Transistoren möglichst zu unterdrücken, was dort durch Erniedrigung der Stromverstärkung der parasitären Transistoren erreicht wird. Dadurch wird der Substratstrom eines entsprechenden Diodenelements vernachlässigbar klein und die Anordnung monolithisch in Bipolartechnik integrierbar. Nach der DE-A 16 39 177 läßt sich dies mittels einer Ausbildung erreichen, bei der in auf einem Halbleiterkörper des einen Leitungstyps angeordneten, durch pn-Übergänge voneinander isolierten Bereichen einer Schicht des entgegengesetzten Leitungstyps zur Ausbildung von Diodenelementen je eine Zone des Substratleitungstyps und je eine Kontaktierungszone eingelassen sind, wobei der Abstand zwischen den als schmale und lange Streifen ausgebildeten Zonen des Substratleitungstyps und den sie umgebenden Kontaktierungszonen möglichst gering und entsprechend der Abbruchspannung gewählt ist und die Breite der Kontaktierungszonen wesentlich größer als die Diffusionslänge der Minoritätenladungsträger in den isolierten Gebieten ist.

Die bekannte in Bipolartechnik realisierte Anordnung hat für jedes Diodenelement eine eigene sogenannte Isolierwanne, was zu einem gewissen Flächenbedarf führt, der jedoch bei hoher Integrationsdichte nicht mehr annehmbar ist. Außerdem bedingt auch die langgestreckte Kontaktierungszone einen entsprechenden Flächenbedarf.

Aus "IBM Technical Disclosure Bulletin", Band 20, April 1975, Seiten 4528 und 4529 ist eine Gleichrichterbrückenschaltung bekannt, die zwei MOS-Feldeffekttransistoren bzw. zwei Dioden in den entsprechenden Brückenzweigen 1 und 2 bzw. 3 und 4 enthält. Die Dioden werden dabei durch die Substrat-Source-pn-Übergänge der Transistoren gebildet. Ein Nachteil der bekannten Schaltung liegt im Spannungsabfall an den die Transistoren enthaltenden Brückenzweigen, so daß die Schaltung für kleine Betriebsspannungen bzw. hohen Stromverbrauch ungeeignet ist.

Die Erfindung wie sie im Anspruch gekennzeichnet ist, löst die Aufgabe, eine monolithisch integrierte Gleichrichterschaltung nach dem Oberbegriff des Anspruchs 1 so auszubilden, daß bei geringem Flächenbedarf und Vermeidung der Wirkung parasitärer Transistoren die Schaltung für kleine Betriebsspannungen oder hohen Stromverbrauch verwendet werden kann.

Die integrierte Gleichrichterbrückenschaltung nach der Erfindung wird somit mit solchen Verfahrensschritten hergestellt, wie sie für CMOS-Schaltungen benötigt werden, da der Aufbau des Halbleiterkörpers dem von CMOS-Schaltungen entspricht, wobei pn-Übergänge sowohl in einer p-Umgebung als auch in einer n-Umgebung zur Verfügung stehen.

Die Erfindung wird nun anhand der Figuren der Zeichnung näher erläutert.

Fig. 1 zeigt das Schaltbild einer üblichen Gleichrichterbrückenschaltung,

Fig. 2 zeigt schematisch die Schnittansicht des Halbleiterkörpers einer möglichen integrierten Gleichrichterbrückenschaltung,

Fig. 3 und Fig. 4 zeigen Ersatzschaltbilder der Anordnung nach Fig. 2,

Fig. 5 zeigt schematisch die Schnittansicht des Halbleiterkörpers einer integrierten Gleichrichterbrückenschaltung nach der Erfindung,

Fig. 6 zeigt das zugehörige Schaltbild,

Fig. 7 zeigt das Schaltbild einer weiteren Ausbildungsform der integrierten Gleichrichterbrückenschaltung nach der Erfindung,

Fig. 8 zeigt typische Spannungsverhältnisse an den Brückenelementen der Anordnung nach Fig. 5 beim Auftreten einer positiven Halbwelle an einer der Wechselspannungseingänge,

Fig. 9 zeigt das zugehörige Schaltbild,

Fig. 10 zeigt das Ersatzschaltbild nach Fig. 5 in das die parasitären Transistoren eingezeichnet sind, und

Fig. 11 zeigt das Ersatzschaltbild einer integrierten Gleichrichterbrückenschaltung nach der Erfindung, in dem ein vertikaler parasitärer npn-Transistor mit einem lateralen parasitären pnp-Transistor eine Vierschichtstruktur bildet.

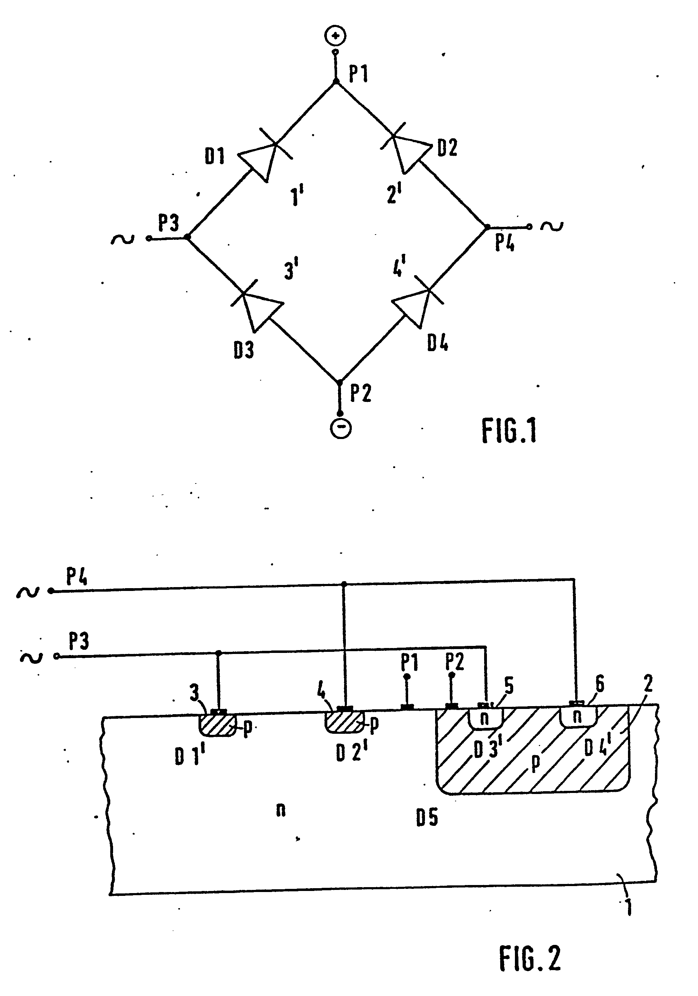

Die Fig. 1 zeigt das Schaltbild einer üblichen Gleichrichterbrückenschaltung, wobei in den Brückenzweigen 1', 2' die Diodenelemente D1, D2 mit ihren Kathode am von den ersteren gebildeten Eckpunkt P1 und die Diodenelemente D3, D4 in den Brückenzweigen 3', 4' mit ihren Anoden am von diesen gebildeten Eckpunkt P2 liegen. An den Eckpunkten P1, P2 wird die Gleichspannung abgenommen. An den von den Brückenzweigen 1', 3' bzw. 2', 4' gebildeten Eckpunkten P3, P4 wird die gleichzurichtende Wechselspannung eingespeist.

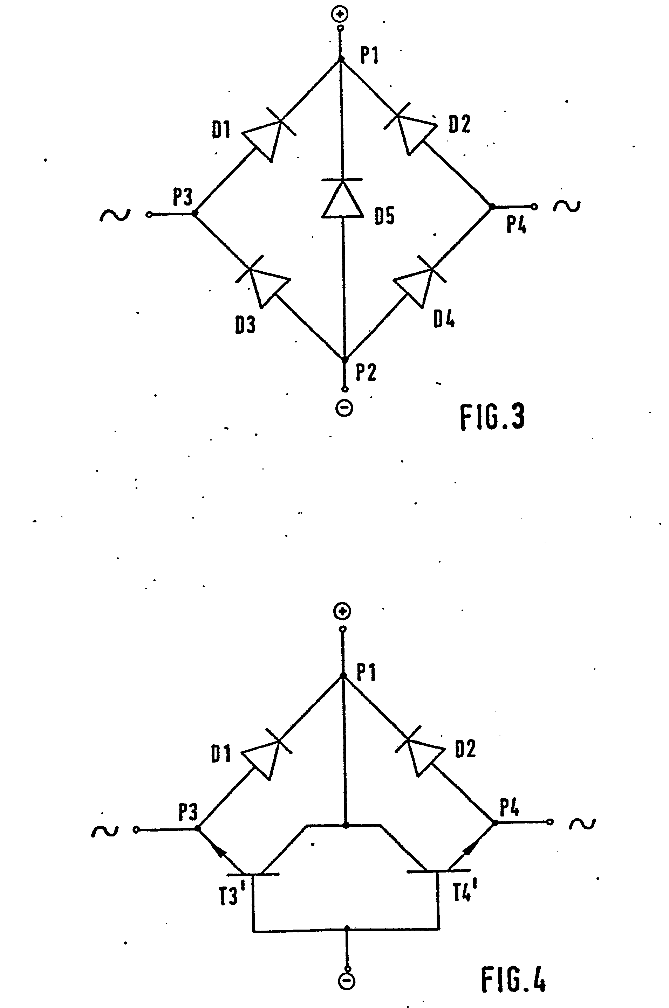

Die Fig. 2 zeigt im Schnitt den möglichen Aufbau eines Halbleiterkörpers einer derartigen Brückenschaltung, in der die Diodenelemente D1...D4 durch die entsprechenden pn-Übergänge realisiert sind. In den n-leitenden Halbleiterkörper 1 sind nach Art der üblichen Planartechnik die p-leitenden Zonen 2, 3, 4 eingesetzt, wobei die Zonen 3, 4 mit dem Halbleiterkörper 1 die pn-Dioden D1' D2' bilden. In die Zone 2 sind zwei n-leitende Zonen 5, 6 eingesetzt, die mit der p-leitenden Zone 2 die pn-Dioden D3', D4' bilden. Durch den pn-Übergang zwischen der Zone 2 und dem n-leitenden Halbleiterkörper 1 entsteht das fünfte Diodenelement D5, das auch in die Ersatzschaltung nach Fig. 3 eingezeichnet ist. Dieses Diodenelement stört nicht, sofern seine Abbruchspannung ausreichend hoch ist.

Die Ersatzschaltung nach Fig. 3 ist jedoch nur für solche Fälle gültig, in denen die Zone 2 so tief in den Halbleiterkörper 1 eingedrungen ist, daß keine parasitären vertikalen npn-Transistoren zwischen den Gebieten 5-2-1 bzw. 6-2-1 entstehen. Derartige Verhältnisse liegen aber gerade nicht vor, wenn der Halbleiterkörper üblicher-CMOS-Schaltungen, deren noch nicht verdrahtetes Grundelement (CMOS-Inverter) aus dem Halbleiterkörper 1 und der Zone 2 besteht, durch die Zonen 3...6 entsprechend Fig. 2 zur Bildung einer Gleichrichterbrückenschaltung ergänzt würde. Es wären nämlich die in der hierfür gültigen Ersatzschaltung nach Fig. 4 anstelle der Diodenelemente D3, D4 gezeigten Transistoren T3',T4' wirksam, die den Gleichspannungsanschluß P1 mit den Wechselspannungsanschlüssen P3, P4 über die Emitter-Kollektor-Strecke jedes Transistors kurzschlössen.

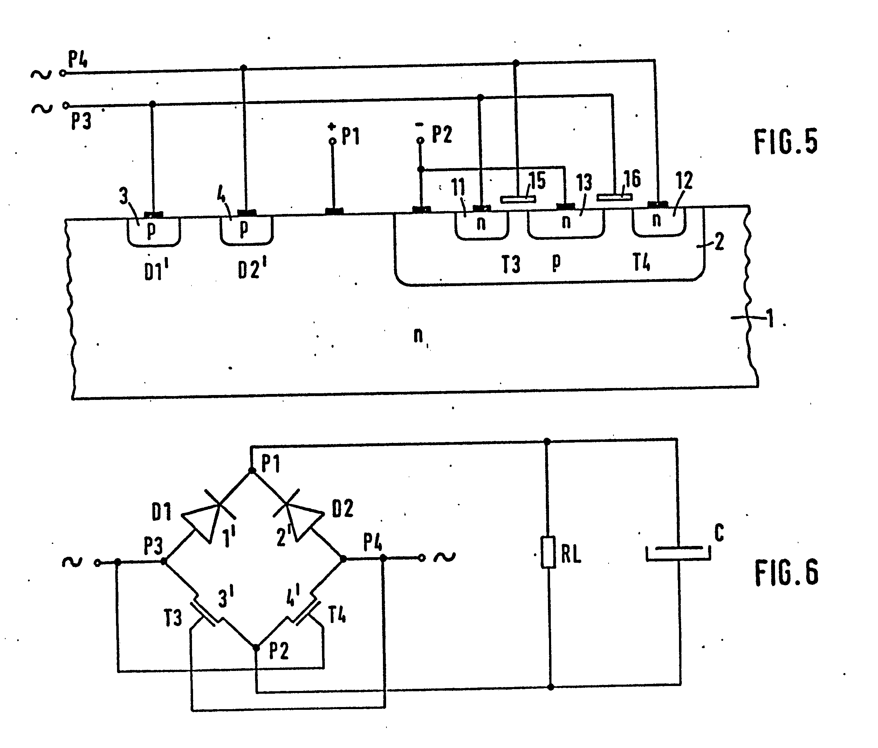

In Fig. 5 ist ein erstes Ausführungsbeispiel der Erfindung gezeigt und in Fig. 6 das entsprechende Schaltbild. Die Gleichrichterbrückenschaltung enthält dabei jeweils im ersten und im zweiten Brückenzweig 1, 2 die beiden pn-Dioden D1', D2', die mit ihren Kathoden am von den beiden Brückenzweigen 1, 2 gebildeten Eckpunkt P1 liegen. Anstelle der beiden anderen Diodenelemente D3, D4 nach Fig. 1 liegen die beiden Isolierschicht-Feldeffekttransistoren T3, T4 vom Anreicherungstyp mit ihrem gesteuerten Strompfad in den Brückenzweigen 3, 4, wobei das Gate des Transistors T3 mit dem Eckpunkt P4 und das des Transistors T4 mit dem Eckpunkt P3 verbunden ist, d.h., die Gates der beiden Transistoren T3, T4 sind über Kreuz an die Wechselspannungseingänge der Gleichrichterbrückenschaltung angeschlossen.

In Fig. 5 sind die Transistoren T3, T4 innerhalb der p-leitenden Zone 2 dadurch gebildet, daß in sie die n-leitende (Source-)Zone 11 des Transistors T3 und die n-leitende (Source)-Zone 12 des Transistors T4 sowie die den beiden Transistoren T3, T4 gemeinsame (Drain-)Zone 13 eingesetzt ist. Die Zonen 11, 13 bzw. 12, 13 sind so mit gegenseitigem Abstand gegeneinander angeordnet, daß sich in bekannter Weise zwischen ihnen der Kanal ausbilden kann, wenn an die über dem Zwischenraum angeordnete Gate-Elektrode 15 bzw. 16 die Spannung angelegt wird. Unter den Gate-Elektroden befindet sich die in Fig. 5 der Einfachheit halber nicht gezeigte Gate-Isolierschicht.

Bei der Anordnung nach der Erfindung fließt über die von der jeweiligen Source-Zone 11, 12 bzw. der gemeinsamen Drain-Zone 13 der Transistoren T3, T4 mit der Zone 2 gebildeten pn-Übergänge kein Strom, der als Basisstrom eines parasitären vertikalen npn-Transistors wirken könnte, solange der Spannungsabfall am jeweiligen Kanal der Transistoren T3, T4, also die Source Drain-Spannung, nicht größer ist als die Schwellspannung der in der Zone 2 gebildeten pn-Übergänge.

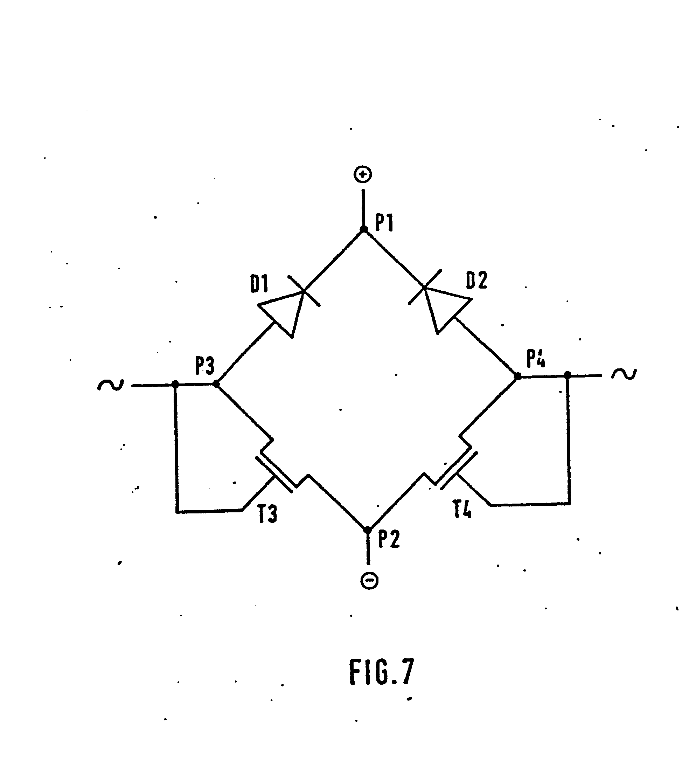

Fig. 7 zeigt das Schaltbild einer zweiten Ausbildungsform der Erfindung, wobei die beiden Transistoren T3, T4 Isolierschicht-Feldeffekttransistoren vom Verarmungstyp sind. Das Gate des Transistors T3 liegt dabei am Endpunkt P3, das des Transistors T4 am Endpunkt P4.

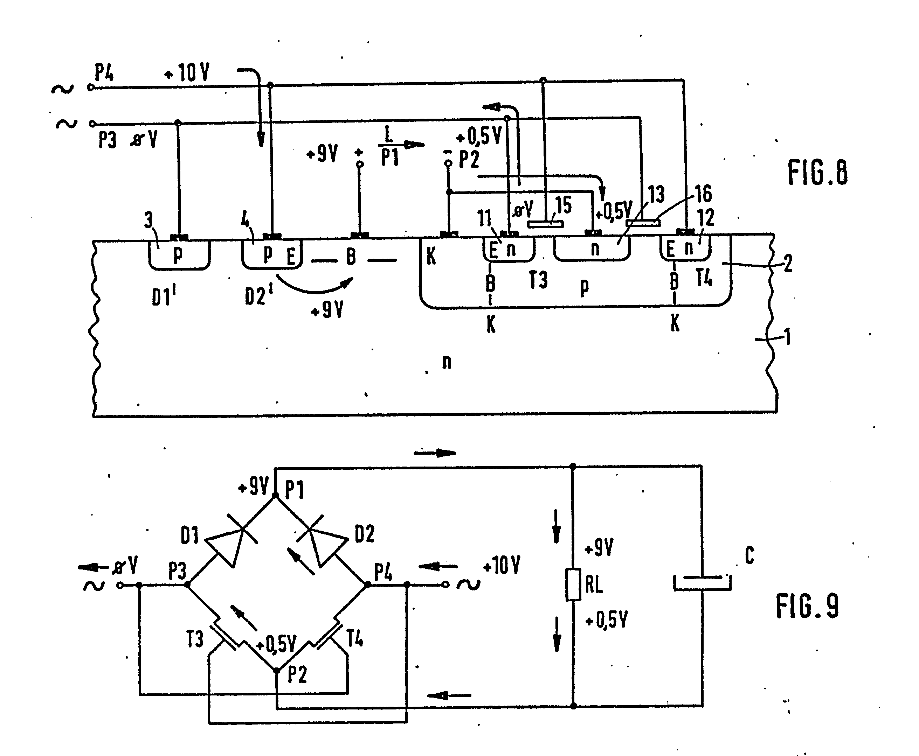

Die erfindungsgemäße Brückenschaltung nach den Fig. 5 und 6 läßt sich durch entsprechende Wahl des Durchlaßwiderstandes der Transistoren T3, T4 so ausbilden, daß die vertikalen parasitären npn-Transistoren bei Überstrom in der Brücke die Ausgangs-Gleichspannung begrenzen. In den Fig. 8 und 9 sind die Spannungsverhältnisse an den Brückenelementen dargestellt, wenn am Eckpunkt P4 im Vergleich zum Eckpunkt P3 eine positive Halbwelle anliegt. Die Pfeile zeigen dabei die Richtung des Stromflusses an. Der Spannungsabfall über dem Kanal des Transistors T3 soll im gewählten Beispiel 0,5 Volt betragen. Das entspricht bei einem Kanalwiderstand von 50 Ohm einen Strom von 10 mA. Die Basis-Emitter-Spannung des parasitären Transistors E-B-K beträgt ebenfalls 0,5 Volt, dieser Transistor ist also noch gesperrt. Steigen Spannung und Strom am Eingang an, so wird bei 14 mA die Schwellspannung des parasitären Transistors von 0,7 Volt erreicht, damit beginnt Strom zu fließen und zwar parallel zur Last RL, also daran vorbei.

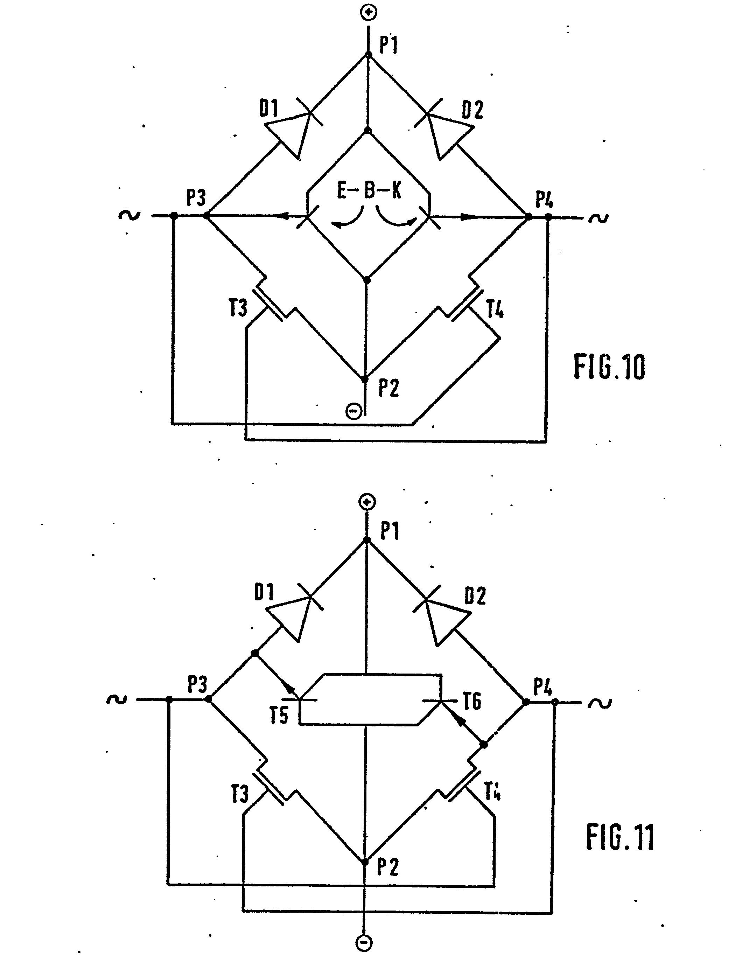

Die Fig. 10 zeigt das entsprechende Ersatzschaltbild mit den parasitären Transistoren E-B-K.

Die Schaltung nach der Erfindung kann andererseits topologisch auch so ausgelegt werden, daß der vertikale parasitäre npn-Transistor mit dem lateralen parasitären pnp-Transistor eine Vierschichtstruktur bildet, die bei einem festgelegten Strom zündet. Auf diese Weise würden Spannung und Verlustleistung über der Brücke stark reduziert. Eine Ersatzschaltung für eine Halbwelle ist in Fig. 11 dargestellt, in der mit T5 der vertikale parasitäre npn-Transistor und mit T6 der laterale parasitäre pnp-Transistor bezeichnet ist.

Die Ausführungsbeispiele zeigen einen n-leitenden Halbleiterkörper 1 und n-leitende Zonen 12, 13, 14 sowie p-leitende Zonen 2, 3, 4. Man kann natürlich auch von einem p-leitenden Halbleiterkörper ausgehen, dann sind die anderen Zonen von entsprechend entgegengesetzter Leitungsart zu wählen.

**Patentanspruch**

1. Monolithisch integrierte Gleichrichter-Brückenschaltung mit einem Halbleiterkörper (1) des einen Leitungstyps und mindestens drei darin eingelassenen Zonen (2, 3, 4) des entgegengesetzten Leitungstyps, ferner mit je einem Diodenelement im ersten, zweiten, dritten und vierten Brückenzweig (1...4), wobei die Diodenelemente (D1, D2) im ersten und zweiten Brückenzweig (1, 2) mit ihren Kathoden am daraus gebildeten ersten Eckpunkt (P1), die Diodenelemente (D3, D4) im dritten und vierten Brückenzweig (3, 4) mit ihren Anoden am daraus gebildeten zweiten Eckpunkt (P2), das erste und dritte Diodenelement (D1, D3) am dritten Eckpunkt (P3) und das zweite und vierte Diodenelement (D2, D4) am vierten Eckpunkt (P4) liegen und wobei zwei Diodenelemente (D1, D2) mittels zweier eingelassenen und PN-Dioden bildenden Zonen (3, 4) realisiert sind und ferner die beiden anderen Diodenelemente (D3, D4) von einem ersten und einem zweiten Isolierschichtfeldeffekttransistor (T3, T4) gebildet werden, die jeweils mit ihrem gesteuerten Strompfad in einem Brückenzweig liegen, gekennzeichnet durch die folgenden Merkmale:
- die beiden Isolierschicht-Feldeffekttransistoren (T3, T4) liegen im dritten und vierten Brückenzweig (3', 4') und sind in einer in das Halbleitersubstrat (1) eingelassenen Zone (2) in CMOS-Technik ausgebildet,
- im Falle von Feldeffekttransistoren des Anreicherungstyps liegt das Gate des ersten Feldeffekttransistors (T3) am vierten Eckpunkt (P4) und das Gate des zweiten (T4) am dritten Eckpunkt (P3) (Fig. 6), oder
- im Falle von Feldeffekttransistoren des Verarmungstyps liegt das Gate des ersten Feldeffekttransistors (T3) am dritten Eckpunkt (P3) und das Gate des zweiten (T4) am vierten Eckpunkt (P4) (Fig. 7).

**Claim**

Monolithic integrated rectifier bridge including a semiconductor body (1) of the one conductivity type and at least three zones (2, 3, 4) of the opposite conductivity type inserted into said body (1), moreover with each time one diode element in the first, second, third and fourth bridge arm (1'...4'), with the diode elemente (D1, D2) in the first and the second bridge arm (1', 2') together with their cathodes being connected to the first corner point (P1) as formed thereby, and the diode elements (D3, D4) being arranged in the third and the fourth bridge arm (3', 4') with their anodes at the eecond corner point (P2) as formed thereby, with the first and the third diode element (D1, D3) being arranged at the third corner point (P3) and the second and the fourth diode element (D2, D4) being arranged at the fourth corner point (P4) with two diode elements (D1, D2) being realized with the aid of two zones (3, 4) let therein and forming pn diodes, and further the two other diode elements (D3, D4) being realized by a first and a second IGFET (T3, T4) each being arranged with their controlled current path in a bridge arm, <u>characterized by the following features:</u>
- the two IGFET (T3, T4) being arranged in the third and in the fourth bridge arm (3', 4') and are formed by CMOS-technology in a zone (2) which is inserted in the substrate (1)
- in the case of field-effect transistors of the enhancement type, the gate of the first field-effect transistor (T3) is connected to the fourth corner point (P4) and the gate of the second field-effect transistor (T4) is connected to the third corner point (P3) (Fig. 6), or
- in the case of field-effect transistore of the depletion type, the gate of the first field-effect transistor (T3) is connected to the third corner point (T3) and the gate of the second field-effect transistor (T4) is connected to the fourth corner point (P4) (Fig. 7).

**Revendication**

1. Pont redresseur en circuit intégré monolithique comportant un corps semi-conducteur (1) d'un type de conductibilite et au moins trois zones (2, 3, 4) du type de conductibilité opposé incluses dans ce corps, les première, deuxième, troisième et quatrième branches du pont (1'...,4') contenant chacune un élément à diode, les éléments à diodes (D1, D2) étant disposés dans les première et deuxième branches du pont (1', 2'), leurs cathodes étant connectés au premier sommet (P1) ainsi forme, tandis que les troisième et quatrième éléments à diodes (D3, D4) sont disposés dans les troisième et quatrième branches du pont (3', 4'), leurs anodes etant connectées au deuxième sommet (P2) ainsi formé, les premier et troisième éléments à diodes (D1, D3) étant connectés du troisième sommet (P3) et les deuxième et quatrième éléments à diodes (D2, D4) étant connectés au quatrième sommet (P4), les premier et deuxième éléments à diodes (D1, D2) étant réalisés à l'aide de deux zones (3, 4) incluses et forment des diodes PN, et les deux autres éléments à diodes (D3, D4) étant constitués par un premier et un deuxième transistor à effet de champ à grille isolée (T3, T4), dont les trajets de courant commandes respectifs sont disposés chacun dans une branche du pont, caractérisé en ce que:
- les deux transistors à effet de champ à grille isolée (T3, T4) sont disposés dans les troisième et quatrième branches du pont (3', 4') respectivement, et sont réalisés en technologie C-MOS, dans une zone (2) incluse dans le substrat semi-conducteur (1),
- dans le cas de transistors à effet de champ à enrichissement, la grille du premier transistor à effet de champ (T3) est connectée au quatrième sommet (P4) et la grille de deuxième transistor à effet de champ (T4) est connectée au troisième sommet (P3) (fig. 6), ou

- dans le cas de transistors à effet de champ à appauvrissement, le grille du premier transistor à effet de champ (T3) est connectée au troisième sommet (P3) et la grille du deuxième transistor à effet de champ (T4) est connectée au quatrième sommet (P4) (fig. 7).

FIG.1

FIG.2

0 052 860

FIG.3

FIG.4

3

FIG.5

FIG.6

FIG.7

FIG.8

P4  + 10 V

~

~  P3  8 V

+9V  +  $\frac{L}{P1}$ →  +0,5V  − P2

8V  15  +0,5V  13  16

3  4  11  12

P  P E  —  B  —  K  E n  n  E n  2

D1'  D2'  B  T3  p  B  T4

+9V  K  K  1

n

0 052 860

+9V  P1

D1  D2

~  8V  P3  P4  ~  +10V

+9V

RL

T3  +0,5V  T4  +0,5V

P2

C

FIG.9

FIG.10

FIG.11